Europäisches Patentamt

European Patent Office

Office européen des brevets

(19)

(11) Publication number: **0 031 659**
**B1**

## (12) EUROPEAN PATENT SPECIFICATION

(45) Date of publication of patent specification: **14.05.86**

(21) Application number: **80304461.9**

(22) Date of filing: **11.12.80**

(51) Int. Cl.⁴: **G 11 C 5/02, G 11 C 7/00, G 11 C 11/24**

(54) A semiconductor memory device having a memory matrix area and a plurality of peripheral circuits.

(30) Priority: **13.12.79 JP 162079/79**

(43) Date of publication of application:
**08.07.81 Bulletin 81/27**

(45) Publication of the grant of the patent:
**14.05.86 Bulletin 86/20**

(84) Designated Contracting States:
**DE FR GB**

(56) References cited:
**DE-A-2 746 336**
**DE-A-2 919 166**
**US-A-3 909 808**
**US-A-4 044 340**
**US-A-4 045 783**
**US-A-4 085 457**
**US-A-4 099 162**
**US-A-4 122 546**
**US-A-4 156 938**

**ELECTRONICS, vol. 53, no. 12, 22nd May 1980,
New York, US POSA "RAM's:What to expect
next: A special report", pages 119-129**

**ELECTRONICS, vol. 49, no. 10, 13th May 1976,
New York, US KUO et al.: "16-K RAM built with
proven process may offer high startup
reliability", pages 81-85**

(73) Proprietor: **FUJITSU LIMITED**
**1015, Kamikodanaka Nakahara-ku**
**Kawasaki-shi Kanagawa 211 (JP)**

(72) Inventor: **Sakurai, Junji**
**7-11, Seta 4-chome**
**Setagaya-ku Tokyo 158 (JP)**

(74) Representative: **Bedggood, Guy Stuart**
**Haseltine Lake & Co. Hazlitt House 28**
**Southampton Buildings Chancery Lane**
**London WC2A 1AT (GB)**

## Description

The present invention relates to a semiconductor memory device, and is concerned for example with the disposition of peripheral circuit blocks in a semiconductor memory having a high density memory matrix, and more particularly for instance with the layout of sense amplifiers connected to bit lines of the memory.

Since memory cell size can be reduced to as little as approximately 1 μm × 1 μm, which is considered to be the limit of current manufacturing accuracy, in a high density memory, particularly in a dynamic RAM (Random Access Memory), a large scale integrated memory device with a bit line width of 1 μm and an inter-line interval of 1 μm can be produced. However, a peripheral circuit block, for example providing address decoders to be connected to word lines or providing sense amplifiers to be connected to bit lines, cannot be accommodated within that minimum size of 1 μm × 1 μm because such a peripheral circuit block includes a large number of elements.

Currently, a sense amplifier is about 30 μm in width and bit line width is several microns.

Therefore, when a memory matrix is integrated with particularly high density as explained above, it is geometrically impossible to arrange peripheral circuits, such as sense amplifiers, in a line crossing the productions of respective bit lines serving the memory cells of such a memory matrix. That is, considering a plurality of parallel bit lines extending from a memory matrix it is impossible to arrange sufficient sense amplifiers to serve all the bit lines in a row or line perpendicular to the bit lines within the space between first and last bit lines. An attempt to provide such an arrangement will bring about a result in which portions of bit lines extending from the memory matrix and connected to the sense amplifiers spread out in the form of a fan and an area between the row of sense amplifiers and the memory matrix will be taken up in a non-useful fashion due to the expansion or fanning out of the bit lines. Moreover, the lengths of the portions of the bit lines which extend to sense amplifiers differ in accordance with the positions of the cells which the bit lines serve, and particularly in the case of a dynamic RAM comprising memory cells each of which is composed of one transistor and one capacitor, the capacities of bit lines, undesirably, become different.

US—A—4 099 162 discloses an arrangement in which two output amplifiers are arranged one partly behind and beyond the other in relation to a decoder circuit for two decoder lines which are respectively connected to the amplifiers. The width of an output amplifier can thus exceed the decoder grid size. Connecting wiring to the output amplifier further from the decoder circuit passes around the side of the nearer output amplifier.

According to the present invention there is provided a semiconductor memory device having a memory matrix area in which memory cells are provided at intersections of row and column wiring lines or wiring line pairs, and a plurality of peripheral circuits connected to row or column wiring lines or line pairs, characterised in that the peripheral circuits connected to a predetermined number of adjacent wiring lines or line pairs are arranged one after another when considered in a direction parallel to the lines or line pairs, in such a manner that the peripheral circuits of the plurality are arranged in ranks, and each peripheral circuit of the plurality has a width corresponding to half the distance between the first and last of 2m adjacent lines or line pairs, a first m peripheral circuits being arranged one after another (considered in a direction parallel to the lines or line pairs) within the distance of a first m adjacent lines or line pairs, on one side of the memory matrix area, and a second m peripheral circuits being arranged one after another (considered in a direction parallel to the lines or line pairs) within the distance of a second m adjacent lines or line pairs, on the other side of the memory matrix area, the first m peripheral circuits being connected to the second m adjacent lines or line pairs which are extended to run alongside the first m peripheral circuits, and the second m peripheral circuits being connected to the first m adjacent lines or line pairs which are extended to run alongside the second m peripheral circuits.

An embodiment of the present invention can provide a semiconductor memory system in which high integration density is realised by facilitating the connections betwen X and Y direction wirings of a highly integrated memory matrix and peripheral circuits of peripheral circuit blocks.

An embodiment of the present invention can provide a semiconductor memory system in which the problem relating to layout which results from a large difference between the density of wirings in X and Y directions of a highly integrated memory matrix and the density of peripheral circuits in peripheral circuit blocks connected to the respective wirings is solved, and in which high integration density is provided through effective use of area.

An embodiment of the present invention can provide a semiconductor memory system in which high integration density is realised by facilitating connections between bit lines of a highly integrated memory matrix and sense amplifiers which are formed with a density different from that of the bit lines.

An embodiment of the present invention can provide a semiconductor memory system in which area is used effectively as a result of facilitation of connections between word lines and/or bit lines of a highly integrated memory matrix and decoder circuits for selecting between such lines.

An embodiment of the present invention can provide a highly integrated dynamic random access memory in which the difficulty in making connections between bit lines of a memory matrix in which memory cells each comprise one transistor and one capacitor are arranged in the form of a matrix with high density, and sense amplifiers connected to the bit lines, which difficulty results from a large difference in size between bit lines and sense amplifiers is overcome, and ineffective use of the area for connections is eliminated.

An embodiment of the present invention can be provided in which memory matrix area having a large number of wirings or wiring pairs crossing in row and column directions and having memory cells arranged at intersections, has the following characteristics: a plurality of peripheral circuit blocks which are to be connected to a predetermined number of adjacent wirings or wiring pairs are sequentially arranged one block after another in the same direction as the wirings or wiring pairs to which they are to be connected in such a manner that at least some of the peripheral circuit blocks are arranged in files or ranks and wirings or wiring pairs extended from the memory matrix region are connected to the peripheral circuit blocks.

Reference is made, by way of example, to the accompanying drawings, in which:—

Figure 1 is a schematic block diagram illustrating the general structure of a conventional semiconductor memory system; and

Figure 2 is a schematic circuit diagram of a part of the structure of a semiconductor memory system embodying the present invention.

Recent semiconductor memory systems are more advanced in the achievement of high integration density for memory cell matrixes because memory cells provided at the intersections of word lines which extend in a row direction, and bit lines which extend in a column direction have been reduced in size by a variety of methods.

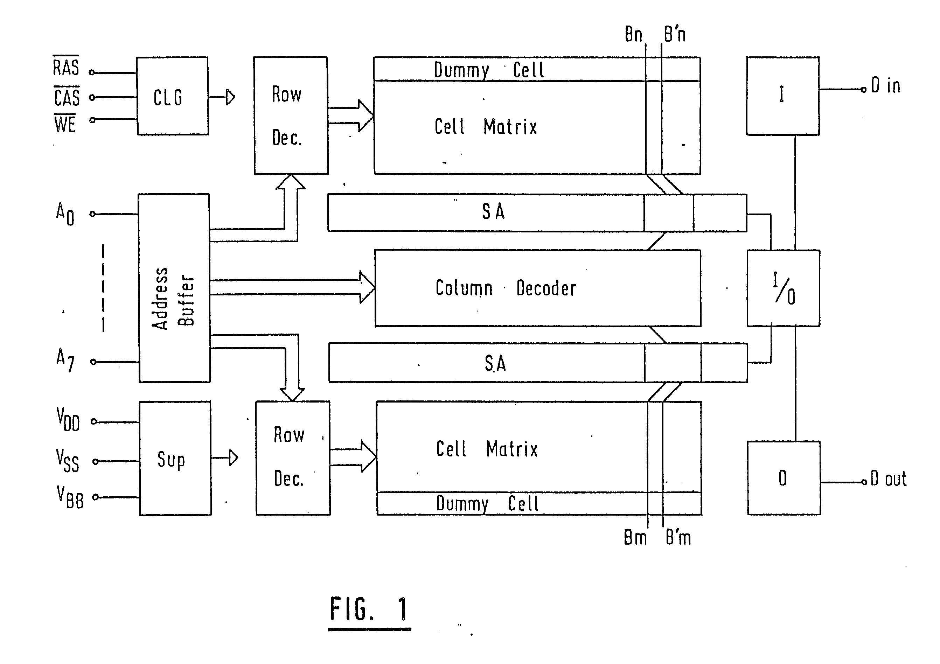

Figure 1 is a block diagram illustrating a conventional semiconductor memory system; in particular Figure 1 outlines the overall structure of a dynamic RAM comprising memory cells each of which is composed of one transistor and one capacitor. SUP is a power supply circuit which receives a variety of power source voltages $V_{DD}$, $V_{SS}$, $V_{BB}$ from circuits external of the RAM and supplies them to the circuits internal of the RAM. CLG is the internal clock generator which receives a row address signal $\overline{RAS}$, a column select signal $\overline{CAS}$ and a write enable signal $\overline{WE}$ from external circuits and supplies predetermined clock signals to internal circuits. At the periphery of a memory cell matrix area, sense amplifiers SA and column decoders, connected to bit line pairs Bn, Bn' and Bm, Bm' etc., and row decoders connected to word lines, which word lines extend in a direction perpendicular to that of the bit line pairs, are arranged. For a memory cell selected by a column decoder and a row decoder on the basis of a signal sent from an address buffer, to which address signals $A_0$, $A_1$, ... $A_7$ are supplied, a sense amplifier senses the content of the cell by comparing a bit line Bn connected to the cell and another bit line Bn' connected to a dummy cell. Thereby data is read as output information $D_{out}$ from an output buffer 0 via an input-output circuit I/O. Namely, sense amplifiers are provided in correspondence to respective bit line pairs.

$D_{in}$ represents input information which can be input to a memory cell via input buffer I and input-output circuit I/O.

In order to increase memory capacity, the memory cell matrix is improved to offer higher integration density by further reducing memory cell size. The dimensions of the bit line pairs and the sense amplifiers are not equal, and as indicated in Figure 1, sense amplifiers arranged in a line cannot be accommodated within the lateral extent of the memory cell matrix area as seen in the Figure. Therefore, the portions of the bit lines which extend for connection with the sense amplifiers spread out in the form of a fan, resulting in inefficient use of area. This contradicts the purpose of realisation of high integration density.

One way to avoid this problem is to provide multiplexer switching circuits and to use the same sense amplifier in common for the plurality of bit line pairs, as described in IEEE Journal of Solid State Circuits, Vol. SC-15, No. 2 April 1980, page 184—189.

However, it is a defect that the extra circuits, such as multiplexer switching circuits and timing clock signals for switching, are needed and a refresh time for memory cells is longer.

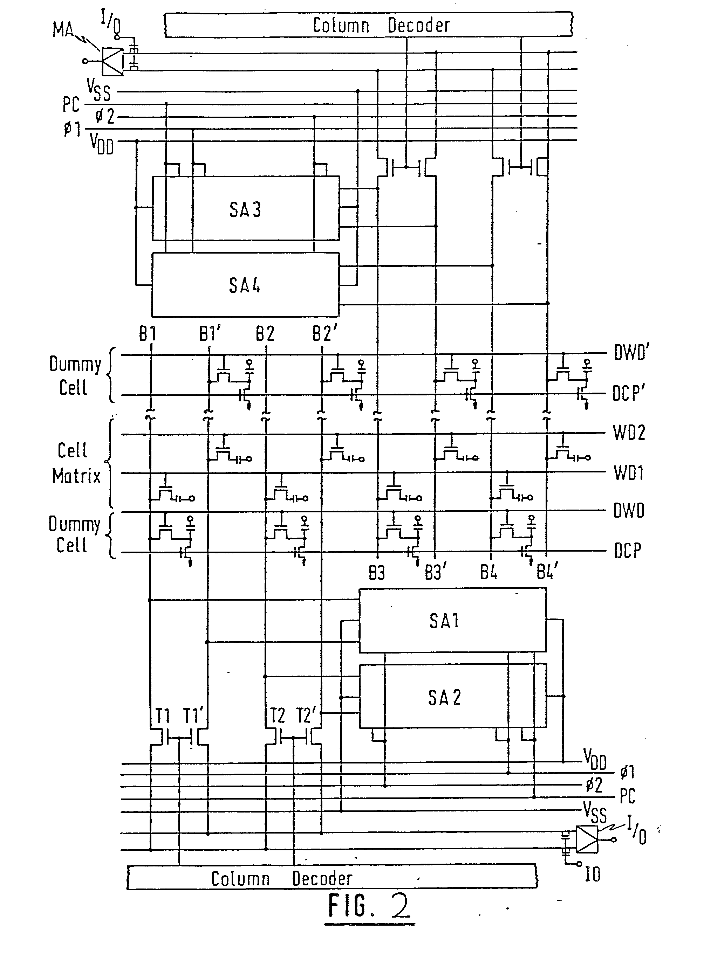

Figure 2 is a schematic diagram showing parts of a memory system embodying the present invention.

In Fig. 2, $B_1$, $B_1'$ to $B_4$, $B_4'$ are bit line pairs, SA1 to SA4 are sense amplifiers. In relation to the cell matrix and dummy cell areas shown in Figs. 2, WD1 and WD2 are word lines, DWD and DWD' are dummy word lines, and DCP and DCP' are signal lines for discharging dummy cells. The bit line pairs are connected to bus lines via gate transistors, e.g. T1, T1' and T2, T2', which are turned ON and OFF under control of column decoders.

$V_{DD}$ and $V_{SS}$ are high level and low level power supply lines respectively, PC indicates a precharge signal line, $\phi_1$ indicates an interrupt signal line and $\phi_2$ indicates a latch signal line. Such lines are connected to each sense amplifier.

The bus lines are connected to input-output circuits I/O, MA, via transistor pairs which are turned ON and OFF under the control of a signal IO, I/O.

In the memory cell matrix of Fig. 2, each memory cell consists of a transistor and a capacitor. Each dummy cell consists of a transistor, capacitor, and a discharging transistor.

Attention is directed to European Patent Application No. 85101832.5, which is divided out of the present application.

In Fig. 3 of the divided-out application the internal constitution of sense amplifiers is shown.

In the embodiment of Figure 2, four bit line pairs $B_1$, $B_1'$ to $B_4$, $B_4'$ are led out to opposite sides of the memory matrix, two bit line pairs being led out to each side, while two sense amplifiers SA1, SA2 are arranged on one side of the memory matrix and another two sense amplifiers SA3, SA4 are arranged on the other side of the memory matrix, along the direction of bit line pairs $B_1$, $B_1'$; $B_2$, $B_2'$; and $B_3$, $B_3'$; $B_4$, $B_4'$.

In the embodiment of Figure 2, the width of each sense amplifier SA1 to SA4 is equal to the width of two bit line pairs, and the portions of bit lines which extend to those sense amplifiers are arranged so as to pass the sides of the sense amplifiers. That is, the bit line portions extending to amplifier SA3, for example, pass to the side of amplifier SA4, which is nearer to the memory matrix. Namely, the sense amplifiers SA1, SA2 are formed in an area on a side of the memory matrix into which the bit line pairs $B_3$, $B_3'$ and $B_4$, $B_4'$ are not led, while the sense amplifiers SA3, SA4 are formed in an area on a side of the memory matrix into which the bit line pairs $B_1$, $B_1'$ and $B_2$, $B_2'$ are not led, and the portions of the bit line pairs $B_3$, $B_3'$ and $B_2$, $B_2'$ for example, leading to sense amplifiers are connected to the sense amplifiers and pass to the side of the sense amplifiers SA1, SA4 and do not cross the sense amplifiers SA1, SA4. The number of bit line pairs and the number of sense amplifiers, for example four pairs or two amplifiers in the embodiment of Figure 2, can be determined in general as follows. In general, a value of m is obtained such that the width of m pairs of bit lines is approximately equal to the width of one sense amplifier, many bit line pairs are divided into blocks each consisting of 2m bit line pairs each, 2m sense amplifiers are provided for each block with m sense amplifiers to one side of the memory matrix in the bit line direction, and m sense amplifiers to the other side of the memory matrix, the m sense amplifiers on opposite sides of the memory matrix being disposed within a width equal to m bit line pairs. Thus, the arrangement as shown in Figure 2 can be obtained by establishing required connections.

The embodiment described above is adapted to a memory system of the folded bit line type, where bit line pairs are provided in parallel (the lines of the pair run alongside one another).

In the above embodiment, the present invention has been explained on the basis of its application to the relationship between bit line pairs and sense amplifiers. The present invention can naturally be adapted for application to the relationship between word lines or word line pairs, or bit lines or bit line pairs and decoder circuits, such as row or column decoders and between word lines or word line pairs or bit lines or bit line pairs and any other peripheral circuits, such as word decoder circuits for selecting and driving word lines or word line pairs, connected thereto.

As explained above, the present invention has the advantage that the word lines or bit lines of a highly integrated memory matrix and peripheral circuits in a peripheral circuit block such as an address decoder, sense amplifiers etc. can be connected without complicating the overall structure and with efficient use of area.

An embodiment of the present invention relates to a semiconductor memory system having a memory matrix area wherein many word lines and bit lines cross mutually in row and column directions and memory cells are arranged at the intersections of the word lines and bit lines with high integration density. A plurality of peripheral circuit blocks which are connected to a plurality of adjacent word lines and bit lines, for example, blocks providing sense amplifiers and decoder circuits, are sequentially arranged in files against the direction of the bit lines or word lines, respectively. Thereby, connections between the word lines or bit lines and peripheral circuits can be made without complicating the structure, and with effective use of areas.

Thus, the present invention provides a semiconductor memory device providing the memory matrix area comprising plurality of wirings or wiring pairs crossed in both row and column directions and the memory cells arranged in the intersection thereof, wherein a plurality of peripheral circuit blocks connected to the adjacent plurality of wirings or wiring pairs in the predetermined number are sequentially arranged in the same direction as said wiring in such a manner that at least a pair of said peripheral circuit block is arranged in files, and said wirings extended from said memory matrix area are connected to said peripheral circuit blocks.

**Claims**

1. A semiconductor memory device having a memory matrix area in which memory cells are provided at intersections of row and column wiring lines or wiring line pairs, and a plurality of peripheral circuits connected to row or column wiring lines or line pairs, characterised in that the peripheral circuits connected to a predetermined number of adjacent wiring lines or line pairs are arranged one after another when considered in a direction parallel to the lines or line pairs, in such a manner that the peripheral circuits of the plurality are arranged in ranks, and each peripheral circuit of the plurality has a width corresponding to half the distance between the first and last of 2m adjacent lines or line pairs, a first m peripheral circuits being arranged one after another (considered in a direction parallel to the lines or line pairs) within the distance of a first m adjacent lines or line pairs, on one side of the memory matrix area, and a second m peripheral circuits being arranged one after another (considered in a direction parallel to the lines or line pairs) within the distance of a second m adjacent lines or line pairs, on the other side of the memory matrix area, the first m peripheral circuits being connected to the second m adjacent lines or line pairs which are extended to run alongside the first m peripheral circuits, and the second m peripheral circuits being connected to the first m adjacent lines or line pairs which are extended to run alongside the second m peripheral circuits.

2. A device as claimed in claim 1, wherein each memory cell comprises one transistor and one capacitor.

3. A device as claimed in claim 1 or 2, wherein the peripheral circuits of the plurality are respective sense amplifiers and are connected to column bit lines or bit line pairs for detecting the potentials thereof.

4. A device as claimed in claim 1 or 2, wherein the peripheral circuits of the plurality are respective word decoders and are connected to row word lines or word line pairs for selecting and driving thereof.

5. A device as claimed in claim 1 or 2, wherein the peripheral circuits of the plurality are column decoders and are connected to column bit lines or bit line pairs for selecting columns.

6. A device as claimed in any preceding claim, being a folded bit line type device.

**Revendications**

1. Dispositif de mémoire à semi-conducteurs comprenant une zone de matrice de stockage avec des cellules de stockage aux croisements de lignes ou de paires de lignes de connexion de rangées et de colonnes, ainsi que des circuits périphériques connectés à des lignes ou des paires de lignes de connexion de rangées ou de colonnes, caractérisé en ce que les circuits périphériques connectés à un nombre prédéterminé de lignes ou de paires de lignes de connexion adjacentes sont disposés l'une après l'autre dans le sens parallèle aux lignes ou paires de lignes, de telle manière que ces circuits périphériques sont disposés en rangs, et chacun de ces circuits périphériques possède une largeur correspondant à la moitié de la distance entre la première et la dernière de 2m lignes ou paires de lignes adjacentes, un premier groupe de m circuits étant disposés l'un après l'autre (dans le sens parallèle aux lignes ou paires de lignes) à l'intérieur de la distance occupée par un premier groupe de m lignes ou paires de lignes adjacentes, d'un côté de la zone de matrice de stockage, et un second groupe de m circuits périphériques étant disposés l'un après l'autre (dans le sens parallèle aux lignes ou paires de lignes) à l'intérieur de la distance occupée par un second groupe de m lignes ou paires de lignes adjacentes de l'autre côté de la zone de matrice de stockage, les premiers m circuits périphériques étant connectés aux secondes m lignes ou paires de lignes adjacentes, s'étendant à côté des premiers m circuits périphériques, et les seconds m circuits périphériques étant connectés aux premières m lignes ou paires de lignes adjacentes, s'étendant à côté des seconds m circuits périphériques.

2. Dispositif selon la revendication 1, dans lequel chaque cellule de stockage comporte un transistor et un condensateur.

3. Dispositif selon la revendication 1 ou 2, dans lequel les circuits périphériques sont des amplificateurs de détection connectés à les lignes ou des paires de lignes de bit de colonne et servant à détecter les potentiels de celles-ci.

4. Dispositif selon la revendication 1 ou 2, dans lequel les circuits périphériques sont des décodeurs de mot connectés à des lignes ou des paires de lignes de mot de rangée et servant à sélectionner et à attaquer celles-ci.

5. Dispositif selon la revendication 1 ou 2, dans lequel les circuits périphériques sont des décodeurs de colonne connectés à des lignes ou des paires de lignes de bit de colonne et servant à sélectionner des colonnes.

6. Dispositif selon l'une quelconque des revendications précédentes, le dispositif étant du type à ligne de bit pliée.

**Patentansprüche**

1. Halbleiterspeichervorrichtung mit einer Speichermatrixfläche, in welcher Speicherzellen an Schnittpunkten von Reihen- und Spaltenverdrahtungsleitungen oder -verdrahtungsleitungspaaren vorgesehen sind, und mit einer Anzahl von peripheren Schaltungen, die mit Reihen- oder Spaltenverdrahtungsleitungen oder -leitungspaaren verbunden sind, dadurch gekennzeichnet, daß die peripheren Schaltungen, die mit einer vorbestimmten Zahl von benachbarten Drahtleitungen oder Leitungspaaren verbunden sind, eine hinter der anderen angeordnet sind, wenn sie in einer Richtung parallel zu den Leitungen oder Leitungspaaren betrachtet werden, derart, daß die peripheren Schaltungen der Anzahl in Rängen angeordnet sind und jede periphere Schaltung der Anzahl eine Breite hat, die dem halben Abstand zwischen der ersten und letzten von 2m benachbarten Leitungen oder Leitungspaaren entspricht, erste m periphere Schaltungen eine hinter der anderen, (betrachtet in Richtung parallel zu den Leitungen oder Leitungspaaren) innerhalb des Abstands einer ersten m benachbarten Leitungen oder Leitungspaaren angeordnet sind, auf einer Seite der Speichermatrixfläche, zweite m peripheren Schaltungen, einer hinter der anderen, (betrachtet in Richtung parallel zu den Leitungen oder Leitungspaaren) innerhalb des Abstands einer zweiten m benachbarten Leitung oder Leitungspaaren angeordnet sind, auf der anderen Seite der Speichermatrixfläche, die ersten m peripheren Schaltungen mit den zweiten m benachbarten Leitungen oder Leitungspaaren verbunden sind, welche sich so erstrecken, daß sie längs den ersten m peripheren Schaltungen verlaufen, und die zweiten peripheren Schaltungen mit den ersten m benachbarten Leitungen oder Leitungspaaren verbunden sind, welche sich so erstrecken, daß sie längs den zweiten m peripheren Schaltungen verlaufen.

2. Vorrichtung nach Anspruch 1, bei welcher jede Speicherzelle einen Transistor und einen Kondensator umfaßt.

3. Vorrichtung nach Anspruch 1 oder 2, bei welcher die peripheren Schaltungen der Anzahl jeweils Leseverstärker sind und mit den Spaltenbitleitungen oder Bitleitungspaaren zum Lesen des Potentials derselben verbunden sind.

4. Vorrichtung nach Anspruch 1 oder 2, bei welcher die peripheren Schaltungen der Anzahl jeweils Wortdecoder sind und mit Reihenwortleitungen oder -wortleitungspaaren zur Auswahl und zum Steuern derselben verbunden sind.

5. Vorrichtung nach Anspruch 1 oder 2, bei welcher die peripheren Schaltungen der Anzahl Spaltendecoder sind und mit Spaltenbitleitungen oder -bitleitungspaaren zur Auswahl der Spalten verbunden sind.

6. Vorrichtung nach einem der vorhergehenden Ansprüche, die eine Vorrichtung vom Typ gefalteter Bitleitungen ist.

FIG. 1

0 031 659

**0 031 659**

**FIG. 2**

2